# EUROPEAN PATENT SPECIFICATION

(11) **EP 4 432 350 B1**
(45) Date of publication and mention of the grant of the patent: **27.08.2025**
(21) Application number: 22903124.0
(22) Date of filing: 09.11.2022
(51) Int. Cl.: H01L 23/498, H05K 1/18, H01L 23/00, H05K 1/02

(54) **PACKAGING SUBSTRATE, SEMICONDUCTOR PACKAGE AND ELECTRONIC DEVICE**
VERPACKUNGSSUBSTRAT, HALBLEITERGEHÄUSE UND ELEKTRONISCHE VORRICHTUNG
SUBSTRAT D'ENCAPSULATION, BOÎTIER DE SEMI-CONDUCTEUR ET DISPOSITIF ÉLECTRONIQUE

(30) Priority: 06.12.2021 CN 202111479104
(43) Date of publication of application: 18.09.2024
(73) Proprietor: Huawei Technologies Co., Ltd., Shenzhen, Guangdong 518129 (CN)
(72) Inventor: PENG, Xiping, Shenzhen, Guangdong 518129 (CN); LIU, Xusheng, Shenzhen, Guangdong 518129 (CN); YUAN, Zhenhua, Shenzhen, Guangdong 518129 (CN)
(74) Representative: Gill Jennings & Every LLP
(86) International application number: PCT/CN2022/130967
(87) International publication number: WO 2023/103701

(56) References cited:
- CN-A- 107 241 857
- CN-A- 107 393 898
- CN-A- 108 695 287
- JP-A- 2019 186 479
- US-A1- 2016 181 682

## Description

### TECHNICAL FIELD

This application relates to the field of electronic device technologies, and in particular, to a package substrate, a semiconductor package, and an electronic device.

### BACKGROUND

With continuous development of computing technologies and communication technologies, a speed of data exchange between a processor and a memory chip of an electronic device is continuously increased. As a result, a requirement on a bit width of a memory bus, storage density, and the like is also continuously increasing. This also imposes a higher requirement on a chip packaging technology. Document JP2019 186479 represents such background package. During manufacturing of a package substrate of a chip, pin arrangement on the package substrate needs to be designed. Usually, on the one hand, electromagnetic crosstalk between pins needs to be reduced, and on the other hand, pin arrangement density needs to be increased. However, an increase in the pin arrangement density causes aggravation of the electromagnetic crosstalk. Therefore, how to implement a high-density and low-crosstalk arrangement mode for pins of a package substrate is a current urgent problem that needs to be resolved.

### SUMMARY

This application provides a use of a package substrate, a semiconductor package, and an electronic device, to reduce a package area of a chip and reduce crosstalk between pins of the chip, to implement a high-density and low-crosstalk pin arrangement mode.

According to a first aspect, this application provides the use of a package substrate in accordance with appended claim 1.

In the foregoing technical solution, the six solder balls included in the solder ball group are arranged in a shape of a parallelogram. This can increase arrangement density of the solder balls, to reduce an area of the solder ball group, so that a package area can be reduced, and manufacturing costs of the semiconductor package can be reduced. In addition, the first solder ball and the fourth solder ball are separately located on the perpendicular bisector of the connection line between the fifth solder ball and the sixth solder ball, so that the first solder ball and the fourth solder ball receive signals with same amplitudes from the fifth solder ball and the sixth solder ball. This helps reduce crosstalk in the solder ball group, to implement a high-density and low-crosstalk pin arrangement mode.

To be specific, in this solution, the four single-ended signal solder balls form the four vertices of the parallelogram, and the two differential signal solder balls are located on sides of the parallelogram. Based on the foregoing structure of the solder ball group, two single-ended signal solder balls are separately located on a perpendicular bisector of a connection line between the two differential signal solder balls. Two signals of the two differential signal solder balls have same amplitudes and opposite phases. Therefore, impact of the differential signal solder balls on the two single-ended signal solder balls on the perpendicular bisector may cancel each other out, to reduce electromagnetic interference caused by a differential signal to a single-ended signal.

Inner angles of the parallelogram are not specifically limited. For example, in some possible technical solutions, the inner angles of the parallelogram are 60°, 120°, 60°, and 120° respectively. Alternatively, in some other possible technical solutions, the inner angles of the parallelogram are 45°, 135°, 45°, and 135° respectively.

In some technical solutions, a ground solder ball is provided on a periphery of each solder ball group, to reduce crosstalk between adjacent solder ball groups.

A specific quantity of ground solder balls is not limited. A plurality of ground solder balls may be provided on the periphery of the solder ball group, to form a return ground on the periphery of the solder ball group, and reduce electromagnetic interference between the solder ball group and another solder ball group.

During specific arrangement of ground solder balls, the ground solder ball provided on the periphery of the solder ball group may include 12 ground solder balls, and the 12 ground solder balls are arranged in a hexagonal shape.

The unit region may further include two solder ball groups, and the two solder ball groups may share a plurality of ground solder balls. In this way, a quantity of provided ground solder balls is reduced without affecting a signal anti-interference capability, to reduce an arrangement area of the ground solder balls.

During specific arrangement of the unit region, the two solder ball groups may be arranged axisymmetrically or centrosymmetrically based on a specific case.

During arrangement of the package substrate, two adjacent unit regions may also share a plurality of ground solder balls, to further reduce a quantity of provided ground solder balls, and reduce an arrangement area of the ground solder balls.

According to a second aspect, this application provides a semiconductor package in accordance with appended claim 8.

According to a third aspect, this application provides an electronic device in accordance with appended claim 9.

### BRIEF DESCRIPTION OF DRAWINGS

FIG. 1 is a diagram of a structure of an electronic device according to an embodiment of this application;
FIG. 2 is a diagram of a structure of a package substrate according to an embodiment of this application;
FIG. 3 is a diagram of an arrangement structure of solder balls on a package substrate according to an embodiment of this application;
FIG. 4 is a diagram of another arrangement structure of solder balls on a package substrate according to an embodiment of this application;
FIG. 5 is a diagram of another arrangement structure of solder balls on a package substrate according to an embodiment of this application;
FIG. 6 is a diagram of another arrangement structure of solder balls on a package substrate according to an embodiment of this application;
FIG. 7 is a diagram of another arrangement structure of solder balls on a package substrate according to an embodiment of this application;
FIG. 8 is a diagram of an arrangement structure of unit regions on a package substrate according to an embodiment of this application;
FIG. 9 is a diagram of another arrangement structure of unit regions on a package substrate according to an embodiment of this application;
FIG. 10 is a diagram of a hardware architecture of a double data rate synchronous dynamic random access memory interface of a CPU according to an embodiment of this application; and
FIG. 11 is a diagram of a DDR interface of a CPU according to an embodiment of this application.

### Reference numerals:

10: electronic device; 11: circuit board;
12: semiconductor package; 011: byte unit;
121: chip; 122: package substrate;
123-substrate body; 124-unit region;
125: solder ball group; 125a: first solder ball;
125b: second solder ball; 125c: third solder ball;
125d: fourth solder ball; 125e: fifth solder ball;
125f: sixth solder ball; 126: ground solder ball.

### DESCRIPTION OF EMBODIMENTS

To make objectives, technical solutions, and advantages of this application clearer, the following further describes this application in detail with reference to accompanying drawings.

Reference to "an embodiment", "some embodiments", or the like described in this specification indicates that one or more embodiments of this application include a specific feature, structure, or characteristic described with reference to embodiments. Therefore, statements such as "in an embodiment", "in another embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

During specific manufacturing of a semiconductor package, a chip is usually placed on a package substrate, and a pin on the chip is electrically connected to a solder ball on the package substrate by using a gold wire bonding or flip chip technology or the like. Then the chip and the package substrate are packaged to form a semiconductor package. An external pin of the semiconductor package may be electrically connected to a printed circuit board (PCB), to implement a connection between the chip and an external circuit, and the chip may be further electrically connected to another component through a wire on the PCB. It should be noted that, in this application, the chip is a die formed by cutting a wafer, and the die has a pressure welding point for packaging.

Packaging effect of the semiconductor package directly affects working performance of the chip and a wiring design of the package substrate. Therefore, a semiconductor packaging technology occupies an important position in the semiconductor field. Currently, an important indicator for measuring performance of the chip packaging technology is a ratio of a chip area to a package area, where the chip area is a die area. When the chip area is determined, a smaller ratio indicates a larger package area, to be specific, a larger size of the semiconductor package. This causes a decrease in a manufacturing yield of the semiconductor package, and further increases manufacturing costs. A ratio closer to 1 indicates a smaller package area. In this case, a manufacturing yield of the semiconductor package increases, and manufacturing costs may also be correspondingly reduced. Therefore, a smaller package area is better. For the package substrate, pin arrangement density of the package substrate is an important factor that affects the package area. If the package area is reduced, the pin arrangement density needs to be increased, to improve utilization of pins of the chip. However, an increase in the pin arrangement density of the package substrate causes electromagnetic crosstalk between pins, affecting performance of the chip.

Therefore, this application provides a package substrate, a semiconductor package, and an electronic device, to reduce a package area of a chip and reduce crosstalk between pins of the chip, to implement a high-density and low-crosstalk pin arrangement mode.

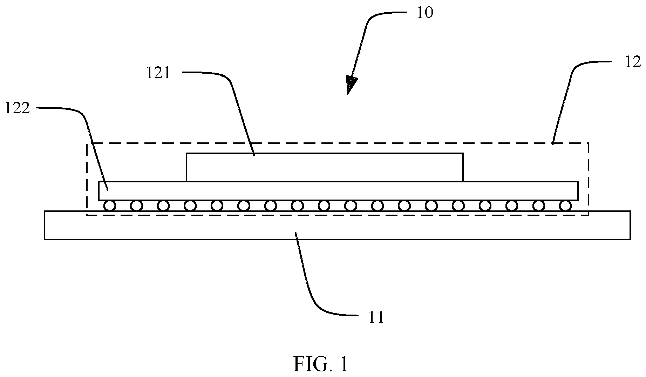

FIG. 1 is a diagram of a structure of an electronic device according to an embodiment of this application. As shown in FIG. 1, the electronic device 10 may include a circuit board 11 and a semiconductor package 12. The semiconductor package 12 may be disposed on the circuit board 11 and is electrically connected to the circuit board 11. The semiconductor package 12 may include a chip 121 and a package substrate 122, where the chip 121 is disposed on the package substrate 122. During packaging of the chip 121, the chip 121 is placed on the package substrate 122, and a pin on the chip 121 is electrically connected to a solder ball on the package substrate 122 by using a gold wire bonding or flip chip technology or the like.

In this application, the electronic device 10 may be a switch, a router, a computer, a server, a communication device, or the like. The semiconductor package 12 may be fastened to the circuit board 11 through welding. The circuit board 11 is provided with signal pins. External pins of the semiconductor package 12 may be connected to the signal pins, and are electrically connected to a wire of the circuit board 11 and another component through the signal pins, to implement an electrical connection between the chip 121 in the semiconductor package 12 and an external circuit.

The following specifically describes the package substrate 122 in this application with reference to accompanying drawings.

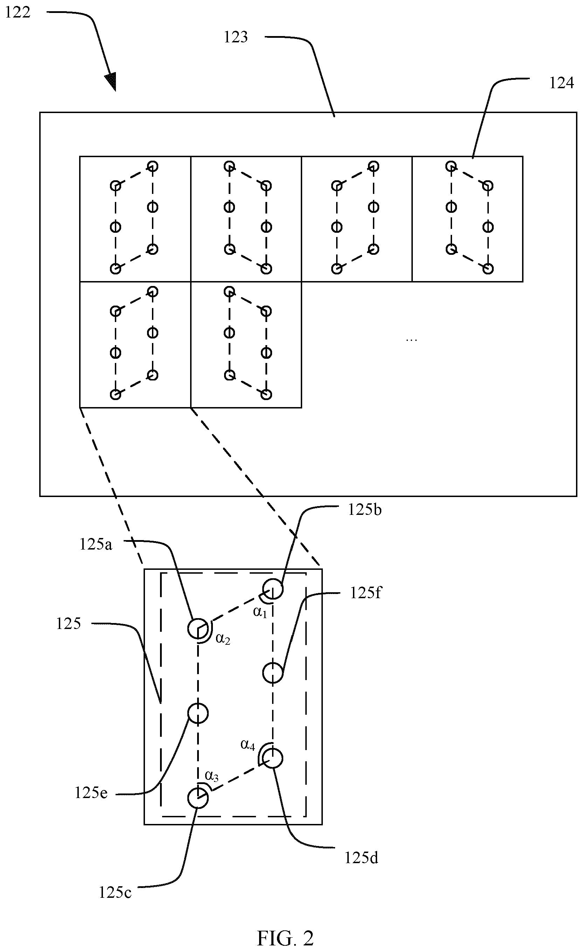

FIG. 2 is a diagram of a structure of a package substrate according to an embodiment of this application. As shown in FIG. 2, the package substrate 122 may include a substrate body 123. The substrate body 123 is provided with a plurality of unit regions 124. Each unit region 124 may include one or more solder ball groups 125. In other words, each unit region 124 may include at least one solder ball group 125. It should be noted that, in descriptions of this application, "a plurality of" means at least two. In some embodiments, each unit region 124 may include one solder ball group 125. Therefore, two adjacent unit regions 124 may correspond to a data signal of a single byte unit. In some other embodiments, each unit region 124 may include two solder ball groups 125. Therefore, one unit region 124 may correspond to a data signal of a single byte unit.

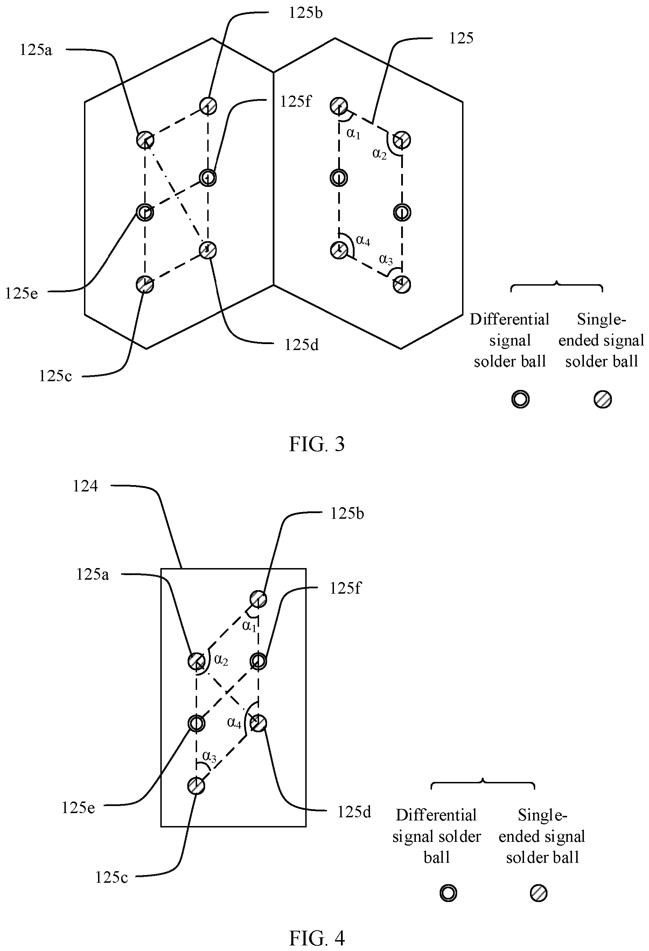

FIG. 3 is a diagram of an arrangement structure of solder balls on a package substrate according to an embodiment of this application. As shown in FIG. 3, the solder ball group 125 may include six solder balls: a first solder ball 125a, a second solder ball 125b, a third solder ball 125c, a fourth solder ball 125d, a fifth solder ball 125e, and a sixth solder ball 125f. The six solder balls are arranged at spacings. During specific arrangement of the solder balls, the first solder ball 125a, the second solder ball 125b, the third solder ball 125c, the fourth solder ball 125d, the fifth solder ball 125e, and the sixth solder ball 125f may be arranged in a shape of a parallelogram. The first solder ball 125a, the second solder ball 125b, the third solder ball 125c, and the fourth solder ball 125d may be located at four vertices of the parallelogram, and the second solder ball 125b and the third solder ball 125c each are adjacent to the first solder ball 125a. To be specific, a connection line between the first solder ball 125a and the second solder ball 125b and a connection line between the third solder ball 125c and the fourth solder ball 125d form a group of opposite sides of the parallelogram. The fifth solder ball 125e may be provided on a side of the parallelogram and is located between the first solder ball 125a and the third solder ball 125c. To be specific, the fifth solder ball 125e may be provided on a side, between the first solder ball 125a and the third solder ball 125c, of the parallelogram. The sixth solder ball 125f is provided on another side of the parallelogram and is located between the second solder ball 125b and the fourth solder ball 125d. To be specific, the sixth solder ball 125f may be provided on a side, between the second solder ball 125b and the fourth solder ball 125d, of the parallelogram. The first solder ball 125a and the fourth solder ball 125d are separately located on a perpendicular bisector (indicated by a dash-dotted line in FIG. 3) of a connection line between the fifth solder ball 125e and the sixth solder ball 125f.

It should be noted that, in accompanying drawings of this application, a dashed line connected between solder balls merely indicates a relationship between locations of the solder balls, and solid lines representing the unit region 124 merely indicate a location of the unit region 124. These dashed lines and solid lines do not exist in a specific structure of the package substrate 122, and therefore do not constitute a limitation on the specific structure of the package substrate 122.

In the foregoing embodiment, the first solder ball 125a and the second solder ball 125b may constitute a first row of solder balls, the fifth solder ball 125e and the sixth solder ball 125f may constitute a second row of solder balls, and the third solder ball 125c and the fourth solder ball 125d may constitute a third row of solder balls. As shown in FIG. 3, solder balls in different rows or columns are arranged in a triangular shape. When a distance between solder balls is determined, a total area of the solder ball group 125 can be reduced in this triangular arrangement mode. Therefore, in the mode in which the six solder balls in the solder ball group 125 are arranged in a shape of a parallelogram, arrangement density of the solder balls can be increased, to reduce a package area and further reduce manufacturing costs of the semiconductor package 12.

The first solder ball 125a and the fourth solder ball 125d are separately located on the perpendicular bisector of the connection line between the fifth solder ball 125e and the sixth solder ball 125f, so that the first solder ball 125a and the fourth solder ball 125d receive signals with same amplitudes from the fifth solder ball 125e and the sixth solder ball 125f. This helps reduce crosstalk in the solder ball group 125, to implement a high-density and low-crosstalk pin arrangement mode. In addition, because the first solder ball 125a and the fourth solder ball 125d are separately located on the perpendicular bisector of the connection line between the fifth solder ball 125e and the sixth solder ball 125f, according to a triangle congruence determining theorem, a distance between the first solder ball 125a and the third solder ball 125c is greater than that between the first solder ball 125a and the second solder ball 125b.

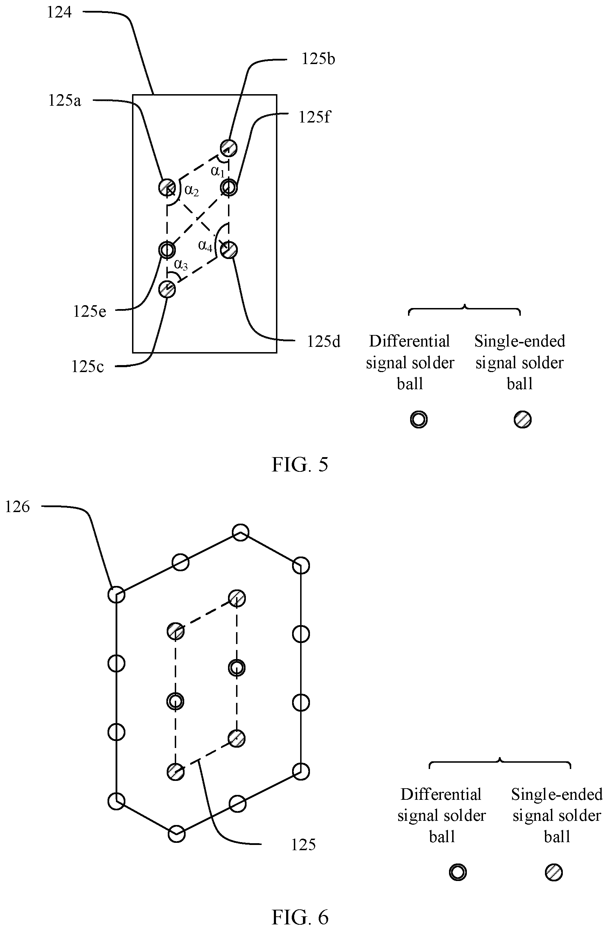

In a specific design, inner angles of the parallelogram are not specifically limited. For example, as shown in FIG. 3, in a specific embodiment, four inner angles α₁, α₂, α₃, and α₄ of the parallelogram may be 60°, 120°, 60°, and 120° respectively. FIG. 4 is a diagram of another arrangement structure of solder balls on a package substrate according to an embodiment of this application. As shown in FIG. 4, in another specific embodiment, four inner angles α₁, α₂, α₃, and α₄ of the parallelogram may be 45°, 135°, 45°, and 135° respectively. FIG. 5 is a diagram of another arrangement structure of solder balls on a package substrate according to an embodiment of this application. As shown in FIG. 5, in another specific embodiment, four inner angles α₁, α₂, α₃, and α₄ of the parallelogram may be 55°, 125°, 55°, and 125° respectively.

Still refer to FIG. 3 and FIG. 4. When the four inner angles α₁, α₂, α₃, and α₄ of the parallelogram may be 60°, 120°, 60°, and 120° respectively, or when the four inner angles α₁, α₂, α₃, and α₄ of the parallelogram may be 45°, 135°, 45°, and 135° respectively, the fifth solder ball 125e is at a midpoint location of a distance between the first solder ball 125a and the third solder ball 125c, and the sixth solder ball 125f is at a midpoint location of a distance between the second solder ball 125b and the fourth solder ball 125d. In this application, "a midpoint location of a distance" is a midpoint location of a connection line. In other words, the fifth solder ball 125e is at a midpoint location of a connection line between the first solder ball 125a and the third solder ball 125c, and the sixth solder ball 125f is at a midpoint location of a connection line between the second solder ball 125b and the fourth solder ball 125d. In this embodiment, the distance between the first solder ball 125a and the third solder ball 125c is twice that between the first solder ball 125a and the second solder ball 125b. In addition, distances between two adjacent solder balls are equal, so that an area of the parallelogram is minimized.

In some embodiments, one unit region 124 may include two solder ball groups 125. The unit region 124 may correspond to a data signal of one byte unit. Each byte unit may usually include eight single-ended signals and four differential signals. The four differential signals may be divided into two pairs of differential signals. Two signals of each pair of differential signals have same amplitudes and opposite phases.

Specifically, in the unit region 124, a first solder ball 125a, a second solder ball 125b, a third solder ball 125c, and a fourth solder ball 125d of each solder ball group 125 may be single-ended signal solder balls, and a fifth solder ball 125e and a sixth solder ball 125f of each solder ball group 125 may be differential signal solder balls. To be specific, the eight single-ended signal solder balls are divided into two groups, and four single-ended signal solder balls in each group form four vertices of a parallelogram; and the two pairs of differential signal solder balls are respectively located on sides of two parallelograms. Based on the foregoing structure of the solder ball group 125, in each solder ball group 125, two single-ended signal solder balls are separately located on a perpendicular bisector of a connection line between two differential signal solder balls. Two signals of the two differential signal solder balls have same amplitudes and opposite phases. Therefore, impact of the differential signal solder balls on the two single-ended signal solder balls on the perpendicular bisector may cancel each other out, to reduce electromagnetic interference caused by a differential signal to a single-ended signal. In addition, around each single-ended signal solder ball, only one single-ended signal solder ball adjacent to the single-ended signal solder ball is provided. To be specific, a small quantity of single-ended signal solder balls are provided around each single-ended signal solder ball. Therefore, electromagnetic crosstalk between single-ended signal solder balls can also be reduced.

FIG. 6 is a diagram of another arrangement structure of solder balls on a package substrate according to an embodiment of this application. As shown in FIG. 6, a ground solder ball 126 may be provided on a periphery of each solder ball group 125, to reduce crosstalk between adjacent solder ball groups 125. Specifically, a quantity of ground solder balls 126 is not limited. For example, in some embodiments, a plurality of ground solder balls 126 may be provided on the periphery of the solder ball group 125, to form a return ground on the periphery of the solder ball group 125, and reduce electromagnetic interference between the solder ball group 125 and another solder ball group 125.

Still refer to FIG. 6. In a specific embodiment, 12 ground solder balls 126 are provided on the periphery of the solder ball group 125. The ground solder balls 126 are arranged in a hexagonal shape. Four sides of the hexagon may be respectively arranged to be parallel to four sides of a parallelogram of the solder ball group 125. This hexagonal arrangement mode can well match the quadrilateral arrangement mode of the solder ball group 125, so that the 12 ground solder balls 126 can be densely provided on an outer side of the solder ball group 125. This can reduce an arrangement area of the ground solder balls 126, so that the package substrate 122 can accommodate more solder balls. In addition, at least three ground solder balls 126 are provided around each single-ended signal solder ball, to effectively reduce electromagnetic interference between signals.

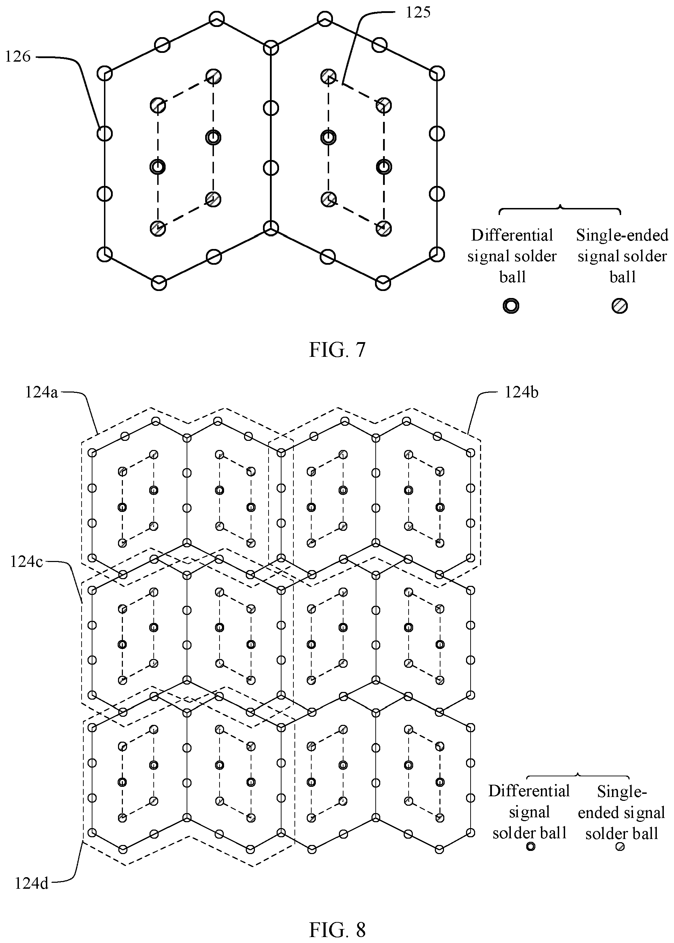

FIG. 7 is a diagram of another arrangement structure of solder balls on a package substrate according to an embodiment of this application. As shown in FIG. 7, two adjacent solder ball groups 125 may share a plurality of ground solder balls 126. In this way, a quantity of provided ground solder balls 126 can be reduced without affecting a signal anti-interference capability, to reduce an arrangement area of the ground solder balls 126. It should be noted that, in this embodiment, two adjacent solder ball groups 125 may be located in one unit region 124, or may be respectively located in two adjacent unit regions 124.

During specific arrangement, a spacing between solder balls is not limited in embodiments of this application, and may be specifically designed according to an actual use requirement. In some embodiments, a spacing between adjacent solder balls may range from 0.8 mm to 1.2 mm. For example, the spacing between adjacent solder balls may be 0.8 mm, 0.9 mm, 1 mm, 1.1 mm, or 1.2 mm.

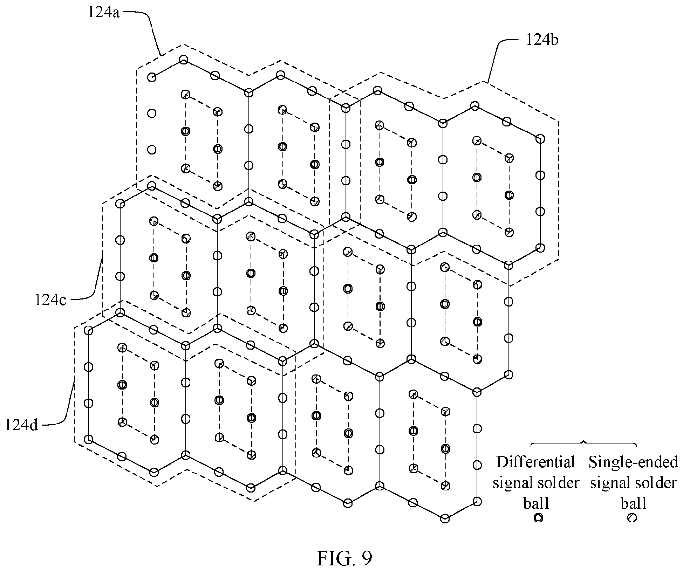

FIG. 8 is a diagram of an arrangement structure of unit regions on a package substrate according to an embodiment of this application. FIG. 9 is a diagram of another arrangement structure of unit regions on a package substrate according to an embodiment of this application. As shown in FIG. 8 and FIG. 9, in this embodiment of this application, the unit regions 124 may be combined and extended horizontally or vertically, to form a pin region of a package substrate 122. Outermost ground solder balls 126 in the unit region 124 are arranged in a hexagonal shape. Therefore, in a specific design, along a row direction or a column direction, two adjacent unit regions 124 may be arranged in a staggered manner, and may share a plurality of ground solder balls 126 in adjacent parts. To be specific, a right-side vertical side edge of a left-side unit region 124a and a left-side vertical side edge of a right-side unit region 124b may share four ground solder balls 126, and a lower inclined side edge of an upper unit region 124c and an upper inclined side edge of a lower side unit region 124d may share two ground solder balls 126. This can reduce an arrangement area of ground solder balls 126. In addition, the left-side and right-side unit regions 124 may share some ground solder balls 126, and the upper and lower unit regions 124 may share some ground solder balls 126, so that a quantity of arranged ground solder balls 126 can be reduced without affecting a signal anti-interference capability. During specific arrangement of the unit regions 124, as shown in FIG. 8, two solder ball groups 125 in two adjacent unit regions 124 may be arranged axisymmetrically, to be specific, arranged in a butterfly shape. Alternatively, as shown in FIG. 9, two solder ball groups 125 in two adjacent unit regions 124 may be arranged centrosymmetrically.

In the foregoing embodiments of this application, the chip 121 may be a central processing unit (CPU) chip. To be specific, the package substrate 122 may be configured to package a CPU.

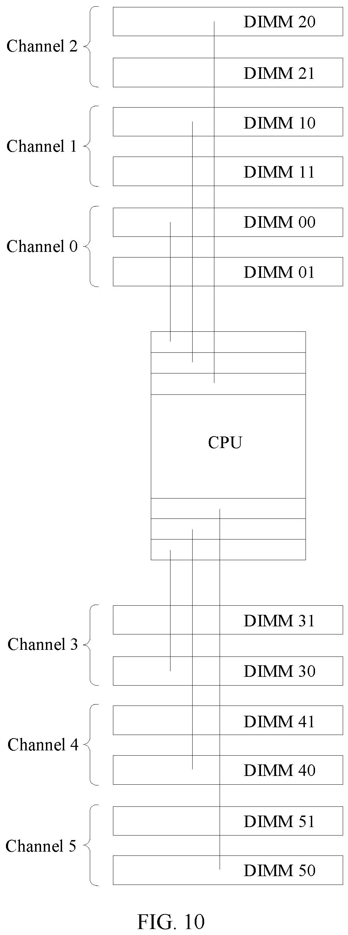

FIG. 10 is a diagram of a hardware architecture of a double data rate synchronous dynamic random access memory (DDR SDRAM) interface of a CPU according to an embodiment of this application. As shown in FIG. 10, the CPU side usually includes a plurality of DDR channels, and each DDR channel may drive and be connected to one or more memory modules, for example, dual in-line memory modules (DIMM). The channel may be a memory channel configured by the CPU, and memory bandwidth of one channel is usually 32 bits or 64 bits.

In a specific embodiment, the CPU may include six DDR channels: a channel 0, a channel 1, a channel 2, a channel 3, a channel 4, and a channel 5. The channel 0 may be connected to two memory modules: a DIMM 00 and a DIMM 01. The channel 1 may be connected to two memory modules: a DIMM 10 and a DIMM 11. The channel 2 may be connected to two memory modules: a DIMM 20 and a DIMM 21. The channel 3 may be connected to two memory modules: a DIMM 30 and a DIMM 31. The channel 4 may be connected to two memory modules: a DIMM 40 and a DIMM 41. The channel 5 may be connected to two memory modules: a DIMM 50 and a DIMM 51. It should be understood that the CPU in this embodiment of this application is not limited to the architecture shown in FIG. 10. A quantity of channels of the CPU and a quantity of memory modules correspondingly connected to each channel may be set according to an actual requirement. Details are not described herein.

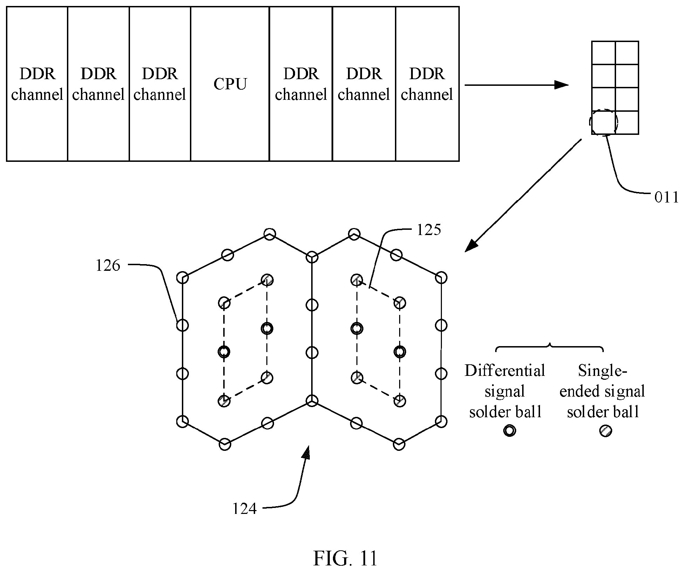

FIG. 11 is a diagram of a DDR interface of a CPU according to an embodiment of this application. As shown in FIG. 11, a DDR channel on the CPU side may include a plurality of byte units 011 that include 8 bits each. It can be understood that, when memory bandwidth of the DDR channel is 32 bits, the DDR channel may include four byte units 011; or when memory bandwidth of the DDR channel is 64 bits, the DDR channel may include eight byte units 011. The embodiment shown in FIG. 11 is described by using an example in which the memory bandwidth of the DDR channel is 64 bits.

In this embodiment, each byte unit 011 may correspond to one unit region 124, in other words, each byte unit 011 may correspond to two solder ball groups 125. For a DDR channel whose memory bandwidth is 64 bits, each DDR channel corresponds to eight unit regions 124, and the eight unit regions 124 may be arranged in a 4×2 (4 indicates a quantity of rows in which the eight unit regions 124 are arranged, and 2 indicates a quantity of columns in which the eight unit regions 124 are arranged) arrangement mode shown in FIG. 11, or may be arranged in a 2×4 (2 indicates a quantity of rows in which the eight unit regions 124 are arranged, and 4 indicates a quantity of columns in which the eight unit regions 124 are arranged) arrangement mode, or may be arranged in one row or one column. Specifically, arrangement may be performed based on space division on the package substrate 122. This is not limited in this application.

An experiment shows that, when the package substrate 122 provided in embodiments of this application is used to package a CPU and a parallelogram-shaped pin arrangement solution is used for the solder ball group 125, electromagnetic crosstalk between DDR data signals can be reduced to -33.5 dB. In addition, if a use area of a unit region 124 arranged in a trapezoidal shape is defined to be 1, a use area of the unit region 124 arranged in the mode in embodiments of this application is approximately 0.95. Therefore, a package area can be effectively reduced. If a use area of a unit region 124 arranged in an arrow shape is defined to be 1, a use area of the unit region 124 arranged in the mode in embodiments of this application is approximately 0.92.

Therefore, in the pin layout solution used for the package substrate 122 in embodiments of this application, electromagnetic crosstalk between DDR data signals can be reduced to enable a CPU to support a higher DDR operation rate, and utilization of pins on the package substrate 122 can also be improved, to effectively reduce a package area and therefore help reduce manufacturing costs of a semiconductor device.

The terms used in the foregoing embodiments are merely intended to describe specific embodiments, but are not intended to limit this application. The singular expressions "one", "a", "the", "the foregoing", "this", and "the one" used in this specification and the appended claims of this application are also intended to include an expression such as "one or more", unless the opposite is explicitly indicated in the context thereof.

## Claims

1. Use of a package substrate (122), comprising a substrate body (123), wherein the substrate body (123) is provided with a plurality of unit regions, the unit region comprises at least one solder ball group (125), and the solder ball group (125) comprises a first solder ball (125a), a second solder ball, a third solder ball (125c), a fourth solder ball (125d), a fifth solder ball (125e), and a sixth solder ball (125f) that are arranged at spacings, wherein
the first solder ball (125a), the second solder ball, the third solder ball (125c), and the fourth solder ball (125d) are respectively located at four vertices of a parallelogram, and the second solder ball and the third solder ball (125c) each are adjacent to the first solder ball (125a); and
the fifth solder ball (125e) is provided on a side of the parallelogram and is located between the first solder ball (125a) and the third solder ball (125c), the sixth solder ball (125f) is provided on another side of the parallelogram and is located between the second solder ball and the fourth solder ball (125d), and the first solder ball (125a) and the fourth solder ball (125d) are separately located on a perpendicular bisector of a connection line between the fifth solder ball (125e) and the sixth solder ball (125f), **characterised in that**
the first solder ball (125a), the second solder ball, the third solder ball (125c), and the fourth solder ball (125d) are used as single-ended signal solder balls, and the fifth solder ball (125e) and the sixth solder ball (125f) are used as differential signal solder balls.

2. Use of the package substrate (122) according to claim 1, wherein inner angles of the parallelogram are 60°, 120°, 60°, and 120° respectively.

3. Use of the package substrate (122) according to any one of claims 1 to 2, wherein a ground solder ball (126) is provided on a periphery of each solder ball group (125).

4. Use of the package substrate (122) according to claim 3, wherein the ground solder ball (126) provided on the periphery of the solder ball group (125) comprises 12 ground solder balls, and the 12 ground solder balls are arranged in a hexagonal shape.

5. Use of the package substrate (122) according to claim 3 or 4, wherein the unit region comprises two solder ball groups, and the two solder ball groups share a plurality of ground solder balls.

6. Use of the package substrate (122) according to claim 5, wherein the two solder ball groups are arranged axisymmetrically or centrosymmetrically.

7. Use of the package substrate (122) according to any one of claims 3 to 6, wherein two adjacent unit regions share a plurality of ground solder balls.

8. Use of a semiconductor package (12), comprising a chip and the package substrate (122) according to any one of claims 1 to 7, wherein the chip is disposed on the package substrate (122).

9. Use of an electronic device (10), comprising a circuit board (11) and using the semiconductor package (12) according to claim 8, wherein the semiconductor package (12) is disposed on the circuit board (11), and the semiconductor package (12) is electrically connected to the circuit board (11).

## Patentansprüche

1. Verwendung eines Verpackungssubstrats (122), das einen Substratkörper (123) umfasst, wobei der Substratkörper (123) mit einer Vielzahl von Einheitsbereichen versehen ist, der Einheitsbereich mindestens eine Lötkugelgruppe (125) umfasst, und die Lötkugelgruppe (125) eine erste Lötkugel (125a), eine zweite Lötkugel, eine dritte Lötkugel (125c), eine vierte Lötkugel (125d), eine fünfte Lötkugel (125e) und eine sechste Lötkugel (125f) umfasst, die in Abständen angeordnet sind, wobei sich die erste Lötkugel (125a), die zweite Lötkugel, die dritte Lötkugel (125c) und die vierte Lötkugel (125d) jeweils an vier Scheitelpunkten eines Parallelogramms befinden und die zweite Lötkugel und die dritte Lötkugel (125c) jeweils der ersten Lötkugel (125a) benachbart sind; und
die fünfte Lötkugel (125e) auf einer Seite des Parallelogramms vorgesehen ist und sich zwischen der ersten Lötkugel (125a) und der dritten Lötkugel (125c) befindet, die sechste Lötkugel (125f) auf einer anderen Seite des Parallelogramms vorgesehen ist und sich zwischen der zweiten Lötkugel und der vierten Lötkugel (125d) befindet, und die erste Lötkugel (125a) und die vierte Lötkugel (125d) sich getrennt auf einer Mittelsenkrechten einer Verbindungslinie zwischen der fünften Lötkugel (125e) und der sechsten Lötkugel (125f) befinden, **dadurch gekennzeichnet, dass**
die erste Lötkugel (125a), die zweite Lötkugel, die dritte Lötkugel (125c) und die vierte Lötkugel (125d) als Single-Ended-Signal-Lötkugeln verwendet werden, und die fünfte Lötkugel (125e) und die sechste Lötkugel (125f) als Differenzsignal-Lötkugeln verwendet werden.

2. Verwendung des Verpackungssubstrats (122) gemäß Anspruch **1,** wobei die Innenwinkel des Parallelogramms jeweils 60°, 120°, 60° und 120° betragen.

3. Verwendung des Verpackungssubstrats (122) gemäß einem der Ansprüche 1 bis 2, wobei eine Masse-Lötkugel (126) an einer Peripherie jeder Lötkugelgruppe (125) vorgesehen ist.

4. Verwendung des Verpackungssubstrats (122) gemäß Anspruch 3, wobei die an der Peripherie der Lötkugelgruppe (125) vorgesehene Masse-Lötkugel (126) 12 Masse-Lötkugeln umfasst und die 12 Masse-Lötkugeln in einer sechseckigen Form angeordnet sind.

5. Verwendung des Verpackungssubstrats (122) gemäß Anspruch 3 oder 4, wobei der Einheitsbereich zwei Lötkugelgruppen umfasst und die beiden Lötkugelgruppen sich eine Vielzahl von Masse-Lötkugeln teilen.

6. Verwendung des Verpackungssubstrats (122) gemäß Anspruch 5, wobei die beiden Lötkugelgruppen achsensymmetrisch oder zentrosymmetrisch angeordnet sind.

7. Verwendung des Verpackungssubstrats (122) gemäß einem der Ansprüche 3 bis 6, wobei sich zwei benachbarte Einheitsbereiche eine Vielzahl von Masse-Lötkugeln teilen.

8. Verwendung eines Halbleitergehäuses (12), umfassend einen Chip und das Verpackungssubstrat (122) gemäß einem der Ansprüche 1 bis 7, wobei der Chip auf dem Verpackungssubstrat (122) angeordnet ist.

9. Verwendung einer elektronischen Vorrichtung (10), die eine Leiterplatte (11) umfasst und das Halbleitergehäuse (12) gemäß Anspruch 8 verwendet, wobei das Halbleitergehäuse (12) auf der Leiterplatte (11) angeordnet ist und das Halbleitergehäuse (12) mit der Leiterplatte (11) elektrisch verbunden ist.

## Revendications

1. Utilisation d'un substrat d'encapsulation (122) comprenant un corps de substrat (123), dans laquelle le corps de substrat (123) est fourni d'une pluralité de régions unitaires, la région unitaire comprend au moins un groupe de billes de soudure (125), et le groupe de billes de soudure (125) comprend une première bille de soudure (125a), une deuxième bille de soudure, une troisième bille de soudure (125c), une quatrième bille de soudure (125d), une cinquième bille de soudure (125e) et une sixième bille de soudure (125f) espacées, dans laquelle
la première bille de soudure (125a), la deuxième bille de soudure, la troisième bille de soudure (125c) et la quatrième bille de soudure (125d) sont respectivement situées aux quatre sommets d'un parallélogramme, et la deuxième bille de soudure et la troisième bille de soudure (125c) sont chacune adjacentes à la première bille de soudure (125a) ; et
la cinquième bille de soudure (125e) est disposée sur un côté du parallélogramme et est située entre la première bille de soudure (125a) et la troisième bille de soudure (125c), la sixième bille de soudure (125f) est disposée sur un autre côté du parallélogramme et est située entre la deuxième bille de soudure et la quatrième bille de soudure (125d), et la première bille de soudure (125a) et la quatrième bille de soudure (125d) sont situées séparément sur une bissectrice perpendiculaire d'une ligne de connexion entre la cinquième bille de soudure (125e) et la sixième bille de soudure (125f), **caractérisée en ce que**
la première bille de soudure (125a), la deuxième bille de soudure, la troisième bille de soudure (125c) et la quatrième bille de soudure (125d) sont utilisées comme billes de soudure de signal asymétrique, et la cinquième bille de soudure (125e) et la sixième bille de soudure (125f) sont utilisées comme billes de soudure de signal différentiel.

2. Utilisation du substrat d'encapsulation (122) selon la revendication 1, dans laquelle les angles intérieurs du parallélogramme sont respectivement de 60°, 120°, 60° et 120°.

3. Utilisation du substrat d'encapsulation (122) selon l'une quelconque des revendications 1 à 2, dans laquelle une bille de soudure de masse (126) est fournie sur une périphérie de chaque groupe de billes de soudure (125).

4. Utilisation du substrat d'encapsulation (122) selon la revendication 3, dans laquelle la bille de soudure de masse (126) disposée sur la périphérie du groupe de billes de soudure (125) comprend 12 billes de soudure de masse, et les 12 billes de soudure de masse sont agencées selon une forme hexagonale.

5. Utilisation du substrat d'encapsulation (122) selon la revendication 3 ou 4, dans laquelle la région unitaire comprend deux groupes de billes de soudure, et les deux groupes de billes de soudure partagent une pluralité de billes de soudure de masse.

6. Utilisation du substrat d'encapsulation (122) selon la revendication 5, dans laquelle les deux groupes de billes de soudure sont agencées de manière axisymétrique ou centrosymétrique.

7. Utilisation du substrat d'encapsulation (122) selon l'une quelconque des revendications 3 à 6, dans laquelle deux régions unitaires adjacentes partagent une pluralité de billes de soudure de masse.

8. Utilisation d'un boîtier de semi-conducteur (12), comprenant une puce et le substrat d'encapsulation (122) selon l'une quelconque des revendications 1 à 7, dans laquelle la puce est placée sur le substrat d'encapsulation (122).

9. Utilisation d'un dispositif électronique (10), comprenant une carte de circuit imprimé (11) et utilisant le boîtier de semi-conducteur (12) selon la revendication 8, dans laquelle le boîtier de semi-conducteur (12) est placé sur la carte de circuit imprimé (11), et le boîtier de semi-conducteur (12) est connecté électriquement à la carte de circuit imprimé (11).
